# EUROPEAN PATENT APPLICATION

(11) **EP 1 744 327 A1**
(43) Date of publication of application: **17.01.2007**
(21) Application number: 05015292.5
(22) Date of filing: 14.07.2005
(51) Int. Cl.: H01B 1/22, H05K 1/09, H01L 21/60

(54) **High thermal cycle conductor system**

(71) Applicant: E.I. du Pont de Nemours and Company, Wilmington, DE 19898 (US)
(72) Inventor: Bacher, Rudolph John, Raleigh, NC 27613 (US); Orzel, Anthony J., Angier, NC 27501 (US); Needes, Christopher R., Chapel Hill, NC 27517 (US)
(74) Representative: Matthews, Derek Peter

(57) **Abstract**

The present invention provides to a method for the production of metallized ceramic substrates that demonstrate superior adhesion characteristics when surface mounted components are soldered to their surface metallization(s) and that provide superior stability when the completed circuits are exposed to high-temperature storage conditions.

## Description

### FIELD OF THE INVENTION

This invention relates to a method for the production of metallized ceramic substrates which demonstrate superior adhesion characteristics when surface mounted components are soldered to their surface metallization(s) and the completed circuits are exposed to high-temperature storage conditions.

### BACKGROUND OF THE INVENTION

An interconnect circuit board is a physical realization of electronic circuits or subsystems made from a number of extremely small circuit elements that are electrically and mechanically interconnected. It is frequently desirable to combine these diverse electronic components in an arrangement so that they can be physically isolated and mounted adjacent to one another in a single compact package and electrically connected to each other and/or to common connections extending from the package.

A standard interconnect circuit board comprises a metallized substrate on which is mounted various active and passive electronic components. A circuit assembly or sub assembly may contain one or more of these interconnect boards to provide the required electronic function(s).

Interconnect circuit boards may be constructed from organic or ceramic materials and the surface mounted components are most commonly attached with one or more solders, conductive glues such as epoxies and or some form of wire or ribbon bonding.

The most dense and complex electronic circuits generally require that the metallized substrate be constructed of several layers of conductors separated by insulating dielectric layers. The conductive layers are interconnected between levels by electrically conductive pathways, called vias, that are formed in the dielectric layers. Such multilayer structures enable more compact circuits than those achievable by use of the traditional single layer circuits.

The current invention relates to ceramic substrates which may be single layer, i.e., alumina only, or multilayer in form and component attachments which are made using soldered connections. It also relates to multilayer circuits which are formed using conventional thick film dielectric materials or LTCC (low temperature co-fired ceramic) materials.

One of the critical elements in the successful use of the materials is that the surface conductor(s) have good soldered adhesion under both thermal aging (isothermal storage at 150°C for at least 1000h) and thermal cycling (typically between a low temperature in the range of -55 to -40°C and a high temperature in the range of 100-150°C for at least 750 cycles) conditions. Furthermore this good soldered adhesion should be operative when the conductor is processed over the dielectric material used to fabricate the multilayer circuit as well as over alumina alone. A consequence of such exposure(s) is the development of stresses in the solder joints used to attach surface mounted components to the metallized substrate. These stresses both static (isothermal conditions) and alternating (thermal cycling conditions) can compromise the mechanical integrity of the joints as time proceeds. The primary reason for the stress development is a mismatch in thermal expansion of the various materials that comprise the joint, namely, the ceramic, the conductor metal, the solder metal, the metal that comprises the leads to the surface-mounted device and the material used to make the device. Through the careful selection of materials, the use of unique design features and the skilled application of compliant underfill materials the stresses can be distributed more evenly, i.e., less concentrated on any one solder joint, and thus less likely to cause mechanical failure of the joint.

The current invention focuses on the selection of top conductor materials and combinations thereof as a means of improving the thermal-cycled adhesion strength or resistance to the mechanical failure of solder joints.

U.S. 5,033,666 to Keusseyan et al. teaches a process for brazing (in the temperature range of 500° to 840°C) a metallized component to a metallized ceramic-based substrate. This process does not utilize soldering techniques.

U.S. 5,431,718 to Lombard et al. provides a high adhesion strength, co-fireable, solderable silver metallization material for use with low-fire ceramics. The metallization material includes the metallization powder as well as an organic vehicle, and an adhesion promoting agent. The combination of elements allows a metallization material which can be cofired at relatively low temperatures necessary for firing ceramic substrate materials while providing an adequate base for soldering subsequent circuit components to the ceramic substrate.

U.S. 4,416,932 to Nair discloses a ceramic substrate having a conductive pattern coating wherein the coating comprises an admixture of finely divided particles of a noble metal or alloy, a low melting, low viscosity glass, a spinel-forming metal oxide and an organo-titanate composition as well as the process for making the same.

Although the above inventions do provide some incremental improvements to the high-temperature adhesion of solder joints, they do not provide a satisfactory solution to the premature failure of solder joints following thermal cycling. Some form of mechanical deterioration that reduces adhesion to below acceptable values occurs before the minimum required number of 750 cycles is attained.

The inventor(s) of the present invention desired to provide a method of.forming a multilayer ceramic circuit that is able to endure and surpass the thermal cycling capabilities generated by implementation of the prior art. The method was required to provide a means whereby the life of solder joints would exceed the required minimum 750 thermal cycles without significant adhesion loss from substrate cracking or adhesion degradation caused by metallurgical reactions propagated because of the prevailing elevated temperatures.

### SUMMARY OF THE INVENTION

The method(s) of the present invention allow for the formation of a metallized single or multilayered circuit from either thick film or LTCC (low temperature co-fired ceramic tape) which comprises:
(a) the application of a first silver or silver-platinum containing conductor composition to a ceramic base which might be fired alumina, fired dielectric, green (unfired) dielectric either thick film or LTCC, AIN, beryllium, or glass, the first conductor composition comprising a metal powder, an inorganic binder, and an organic medium;
(b) the drying of said first conductor composition;
(c) the optional firing of said first conductor composition at a temperature sufficient to drive off the organic medium, to wet the ceramic with said inorganic binder and to sinter said metal powder thereby forming a first metallization layer. An alternative to the foregoing is to not fire the conductor at this point and cofire all layers during the last step of the process;
(d) the application of a second silver or silver-platinum containing conductor composition to said first conductor layer such that said first conductor layer is covered by the second conductor layer, the second conductor composition comprising a metal powder and organic medium;
(e) the drying of said second conductor composition,
(f) the firing of said second conductor composition at a temperature sufficient to drive off the organic medium and to sinter the metal powder of the second conductor composition and thereby forming a second metallization layer. An alternative is to cofire all layers during this step.

### BRIEF DESCRIPTION OF THE DRAWINGS

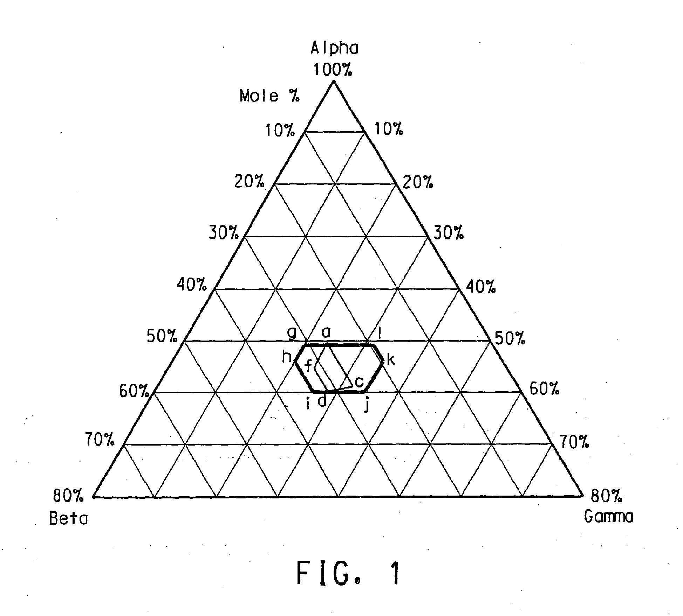

Figure 1 is a ternary phase diagram showing the compositional range for the glass contained in the substrate of one embodiment of the present invention wherein the substrate contains a dielectric paste or tape containing CaO, MgO and/or SrO as alkaline earth modifiers.

### DETAILED DESCRIPTION OF INVENTION

The present invention provides a method of forming ceramic circuits that exhibit thermal cycling adhesion capabilities that exceed those possible from the prior art. In particular, the present invention provides methods that enable greater than 750 thermal cycles being endured without catastrophic adhesion losses in the solder joints.

A method of forming an electronic circuit, either single or multilayer, comprising:
(a) the application of a first conductor composition to a substrate, the first conductor composition comprising a silver metal powder or a mixture of silver and platinum powders, an inorganic binder, and an organic medium;
(b) the drying of said first conductor composition to form a dried first metal layer;
(c) the firing of said substrate and said dried first metal layer at a temperature sufficient to drive off the organic medium and to sinter the metal powder thereby forming a first fired metal conductor layer of a fired dual metal layer;
(d) the application of a second conductor composition to said first fired conductor metal layer such that said first fired metal layer is covered by the second conductor composition, the second conductor composition comprising a silver metal powder or a mixture of silver and platinum powders and an organic medium;
(e) the drying of the said second conductor composition forming a second dried metal layer;
(f) the firing of said second dried metal layer at a temperature sufficient to drive off the organic medium and to sinter the metal powder of the second conductor composition thereby forming a second layer of a dual metal layer.

A method of forming an electronic circuit, whether single or multilayered, whereby the first and second dried metal layers are processed as described above, but are co-fired rather than sequentially fired on the substrate.

A method of forming a multilayered ceramic circuit comprising:
(a) the application of a dielectric composition to previously-fired dielectric layer or layers all on an alumina substrate to form an alumina and dielectric substrate;
(b) the drying of said dielectric composition to form a dried dielectric layer;
(c) the application of a conductor via fill composition to provide eventual interconnection through said dried dielectric layer to connect conductor layers above and below said dried dielectric layer, said via fill composition comprising a metal powder of silver, inorganic additives such as oxides and glasses and a inorganic medium;
(d) the drying of the via fill composition in the vias of said previously dried dielectric layer;
(e) the application of a first conductor composition to said previously dried dielectric layer, and contacting the dried via fill composition in the vias of the dried dielectric layer, the first conductor composition comprising a metal powder consisting essentially of silver alone or a mixture of silver and platinum powders, an inorganic binder, and an organic medium;
(f) the drying of the said first conductor layer to form a first dried conductor layer;
(g) the application of a second conductor composition to said first dried metal layer such that said first dried metal layer is covered by the second conductor composition, the second conductor composition comprising a metal powder consisting essentially of silver alone or a mixture of silver and platinum powders and an organic medium;
(h) the drying of said second conductor layer to form a second dried conductor layer;

The method directly above may further comprise the firing of said alumina and dielectric substrate, dried via fill composition, first conductor layer and second conductor layer, such that said dried dielectric layer, said dried via fill composition and the two (first and second) dried conductor layers are co-fired at a temperature sufficient to drive off the organic medium and to sinter the metal powders in the conductor layers and the ceramic powders in the dielectric layer and thereby forming multiple metallization layers on top of a cofired dielectric layer it, in turn, having been processed on top of previously fired alternating conductor and dielectric layers.

A method of forming a multilayered ceramic circuit comprising the collation and lamination of metallized LTCC layers interconnected with via fill conductor compositions described previously whereby the top metallization layer comprises two dried prints of sequentially printed conductors the whole being cofired to form a typical LTCC metallized substrate.

In all of the above four descriptions the dual metal layer, when properly selected from the correct conductor types, imparts the benefit of improved adhesion and superior solder joint integrity when such structures are subjected to high-temperature exposure. This is the case whether the structures were produced from a single or a multilayer layer process or from a traditional thick film or an LTCC process, in addition the benefit does not depend on the use of a co-firing or a sequential firing strategy.

The main components of each of the thick film conductor compositions of the present invention are described in detail below.

### Glass/ceramic dielectric substrates and substrate compositions

Substrates for use in this invention can include any of the well-known ceramic-based substrates conventional in the art as long as the sintering temperature is less than about 1,000 degrees C (or the melting point of Ag-containing metal). Examples of ceramic-based substrates include the ceramic substrates such as the aluminas, the beryllias, the hafnias, nitrides, and carbides, etc. Also suitable for use as ceramic-based substrates are glass/ceramics and advanced ceramics such as aluminum nitride, silicon carbide, silicon nitride and boron nitride. Additionally, a glass substrate may be used.

In one embodiment, the substrate for use in this invention is an alumina substrate with a dielectric paste or tape (Green Tape™ by E. I. du Pont de Nemours and Company) printed or laminated over the alumina. The dielectric layers may be made by methods known to those skilled in the art, such as by screen printing in the form of a thick film paste or by lamination in the form of a tape.

In particular, the dielectric of one embodiment of the present invention is formed from a thick film dielectric composition which contains a family of amorphous, partially crystallizable alkaline earth zinc silicate glass compositions. These compositions are disclosed in U.S. Patent No. 5,210,057 to Haun et al., which is incorporated herein.

Haun et al. discloses an amorphous partially crystallizable alkaline earth zinc silicate glass consisting essentially of a composition falling within the area defined on a weight points g-l of Figure 1 of the drawing, in which: (1) alpha is SiO2 in admixture with a glass former or conditional glass former selected from the group consisting of no more than 3% Al2O3, 6% HfO2, 4% P2O5, 10% TiO2, 6%ZrO2 and mixtures thereof, with the proviso that the composition contains at least 0.5% ZrO2; (2) beta is an alkaline earth selected from CaO, SrO, MgO, BaO and mixtures thereof, with the proviso that the composition contain no more than 15% MgO and no more than 6% BaO; and (3) gamma is ZnO, the loci of points g-l being as follows: point g - Alpha 48.0, Beta 32.0, Gamma 20.0; point h - Alpha 46.0, Beta 34.0, Gamma 20.0; point i - Alpha 40.0, Beta 34.0, Gamma 26.0; point j - Alpha 40.0, Beta 24.0, Gamma 36.0; point k - Alpha 46.0, Beta 18.0, Gamma 36.0; point k - Alpha 46.0, Beta 18.0, Gamma 36.0; point I - Alpha 48.0, Beta 19.0, Gamma 33.0.

The glass utilized in one Pb-free, Cd-free embodiment of the dielectric utilized in the present invention relates to an alkali-alkaline earth-alumino- borosilicate glass composition comprising, in mole %, 46-66% SiO₂, 3-9% Al₂O₃, 5-9% B₂O₃, 0-8% MgO, 1-6% SrO, 11-22% CaO, and 2-8% M wherein M is selected from oxides of the group of alkali elements and mixtures thereof. Alkali elements are found in group IA of the periodic table. For example, the alkali element oxide may be selected from Li₂O, Na₂O, K₂O and mixtures thereof. The molar ratio of SrO / (Ca + MgO) is between about 0.06 to about 0.45. This ratio range is necessary to assure compatibility properties with conductor materials used in conjunction with the LTCC tape of this invention.

In this Pb-free and Cd-free embodiment, the content of alkali and alkaline earth modifier in the glass is believed to increase the thermal expansion coefficient of glass while providing glass viscosity reduction critical to processing LTCC tape materials. Although the alkaline earth oxide, BaO, could be used to make an LTCC tape, it is found to reduce the chemical resistance, due to its ease of leaching in low pH solutions. For this reason, superior chemical resistance is found for alkaline earth modifier constituents within the ratio limits and mole percents defined above. Strontium oxide imparts superior solderability and low conductor resistivity in conductor material systems applied to outer layers of the tape. The content of strontium oxide in the glass, provides this improved conductor performance when present in the glass at levels including and exceeding 1 mole%. Data show that levels of 1 to 6 mole% provide improved conductor performance. A preferred level of strontium oxide is 1.8 - 3.0 mole%. The existence of the alkali oxides in the glass when used in a green tape improves the sensitivity of the glass to thermal process conditions by controlling the densification and crystallization behavior of the tape. The crucial role of the alkali addition is to provide required flow and densification characteristics to the tape at a desired firing temperature. It performs the function of glass viscosity reduction without affecting required physical and electrical performance of the tape. The type and amounts of alkali ions used to modify the viscosity properties of the glass also have an effect on the electrical loss characteristics of the tape made from the glass.

The glasses described herein may contain several other oxide constituents. For instance, ZrO₂, GeO₂, and P₂O₅ maybe partially substituted for SiO₂ in the glass as follows, in mole% based on total glass composition: 0-4 mole% ZrO₂, 0-2 mole% P₂O₅, and 0-1.5 mole% GeO₂. Additionally 0-2.5 mole%, based on total glass composition, CuO may be partially substituted for the alkali and/or the alkaline earth constituents. A factor for the suitability of an LTCC tape formulation utilizing glass as a constituent is the required compatibility with conductors, and passive materials utilized as circuit components within and on the surface of the tape. This includes physical constraints such as suitable thermal expansion and the attainment of suitable levels of density and strength of the tape, the latter of which is enabled by the suitability of the glass viscosity to provide a tape in the required thermal processing temperature range.

The glasses described herein are produced by conventional glass making techniques. More particularly, the glasses may be prepared as follows. Glasses are typically prepared in 500-1000 gram quantities. Typically, the ingredients are weighted, then mixed in the desired proportions, and heated in a bottom-loading furnace to form a melt in a platinum alloy crucible. Heating is typically conducted to a peak temperature (1500-1550°C) and for a time such that the melt becomes entirely liquid and homogeneous. The glass melts are then quenched by pouring on the surface of counter rotating stainless steel rollers to form a 10-20 mil thick platelet of glass or by pouring into a water tank. The resulting glass platelet or water quenched frit is milled to form a powder with its 50% volume distribution set between 1-5 microns. The resulting glass powders are formulated with filler and medium into thick film pastes or castable dielectric compositions.

The glass when incorporated into a tape is compatible with co-fired thick film conductor materials. The glass in the tape does not flow excessively upon firing. This is due to the partial crystallization of the glass, which is initiated by the reaction between a ceramic filler, typically Al₂O₃, and the glass. The glass, which remains following the partial crystallization, is changed to a more refractory glass. This eliminates staining of the tape with the conductor material and allows solder wetting or chemical plating of the thick film conductor material. Solder wetting is an important feature to allow connection of the ceramic circuit to external wiring such as on a printed circuit board. If chemical plating of thick film conductors is applied to surface layers of the tape, low pH plating baths can release ions from the surface of the tape contaminating the plating bath. For this reason, the glass found in the tape minimizes the release of glass constituents by chemical corrosion in reduced pH solutions.

Additionally, the glass found in the tape also minimizes the release of glass constituents by chemical corrosion in strong basic solutions.

### Conductor Compositions

A thick film conductor composition contains a functional phase that imparts appropriate electrically properties to the composition; a binder phase which provides both cohesion to the functional phase and adhesion to the substrate on which it is applied during firing; and an organic phase which acts as a carrier for the functional and binder phases and enables the screen printing process. Screen printing is the primary method of transferring the conductor composition to the substrate. The functional phase comprises individual metal powders or mixtures of metal powders. The inorganic binder phase comprises glass frit and individual oxide powders and mixtures thereof. The organic phase is typically a solution of polymer(s) in solvent(s).

### A. First conductor composition

### Silver or silver platinum functional powders

The functional phase of the first conductor composition comprises silver powder alone or a mixture of silver and platinum powders. In one embodiment, the total metal functional phase of the composition is 68 percent by weight and both silver and platinum are present in the ratio of 76 parts to 1 part respectively.

### Inorganic Binder of First Conductor Composition

In one embodiment the inorganic binder of the first conductor composition is a Bi,Pb,Si oxide glass in combination with ZnO. The inorganic binder of this embodiment comprises 7.2 weight % of the total first conductor composition. The binder was chosen for:
(a) its ability to maximize fired adhesion to the substrate without causing any reduction of the mechanical strength of the substrate.
(b) its ability to promote the sintering of the functional phase to maximize the density of the fired metallic film.
(c) the ability of the fired film to dewet solder, generally an undesirable feature of a conductor but in this case desirable, through the formation of a silica-rich glass on its surface.

### Organic Medium

The inorganic components are typically mixed with an organic medium by mechanical mixing to form viscous compositions called "pastes", having suitable consistency and rheology for printing. A wide variety of inert liquids can be used as organic medium. The organic medium must be one in which the inorganic components are dispersible with an adequate degree of stability. The rheological properties of the medium must be such that they lend good application properties to the composition, including: stable dispersion of solids, appropriate viscosity and thixotropy for screen printing, acceptable unfired "green" strength, appropriate wettability of the substrate and the paste solids, a good drying rate, and good firing properties. The organic medium is typically a solution of polymer(s) in solvent(s). Additionally, a small amount of additives, such as surfactants, may be a part of the organic medium. The most frequently used polymer for this purpose is ethyl cellulose. Other examples of polymers include ethylhydroxyethyl cellulose, wood rosin, mixtures of ethyl cellulose and phenolic resins, polymethacrylates of lower alcohols, and monobutyl ether of ethylene glycol monoacetate can also be used. The most widely used solvents found in thick film compositions are ester alcohols and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In addition, volatile liquids for promoting rapid hardening after application on the substrate can be included in the vehicle. Various combinations of these and other solvents are formulated to obtain the viscosity and volatility requirements desired.

The ratio of organic medium in the thick film composition to the inorganic components in the dispersion is dependent on the method of applying the paste and the kind of organic medium used, and it can vary. Usually, the dispersion will contain 50-95 wt % of inorganic components and 5-50 wt % of organic medium (vehicle) in order to obtain good coating.

### B. Second Conductor Composition

The second conductor composition is a silver-containing composition dispersed in an organic medium. The second conductor composition may or may not contain some platinum powder. Additionally, the composition may or may not contain any inorganic binder materials.

The second conductor composition is applied over the first conductor composition. Some benefit can be accrued by incomplete coverage of the first conductor composition.

### Silver or silver platinum functional powders

The functional powder of the second conductor composition is a silver-containing powder. As mentioned previously the functional powder may also contain some platinum. If platinum is present its preferred compositional range is 0.3 to 3.5 weight percent.

In one embodiment, which is sold as product number 5082 by E. I. du Pont de Nemours and Company, the composition contains 0.75% by weight and the ratio of silver to platinum is 134 parts to 1 part respectively.

### Inorctanic Binder

The second conductor composition may or may not contain an inorganic binder. If a binder is part of the second conductor composition it provides some protection if there is a misprint of the first conductor layer. More importantly, it also reacts with the glass on the surface of the first conductor composition and provides an enhanced barrier to diffusion of tin from the solder into the fired film. Tin diffusion into the fired film is one of the adhesion degrading mechanisms that operate during high temperature exposure of the solder joint.

In one embodiment the inorganic binder is contains 1.7 weight % glass and 1.3 weight % Pb and Bi oxides, based on total weight percent of the second conductor composition.

### Organic Medium

The organic medium for the second conductor composition may be the same as detailed above for the first conductor composition organic medium.

### APPLICATION

The method of the present invention may be used in conjunction with dielectric layers of uncured ceramic material, such as Green Tape™ or paste, to form a multilayer electronic circuit. The dielectric layers may be formed either by screen printing in the form of a thick film paste or by lamination in the form of a tape.

Green Tape™ is typically used as a dielectric or insulating material for multilayer electronic circuits. A sheet of Green Tape™ is blanked with registration holes in each corner to a size somewhat larger than the actual dimensions of the circuit. To connect various layers of the multilayer circuit, via holes are formed in the Green Tape™. This is typically done by mechanical punching, however, any suitable method may be utilized. For example, a sharply focused laser can be used to volatilize and form via holes in the Green Tape™.

The interconnections between layers are formed by filling the vias with a thick film conductive composition. In the case of this invention, a thick film conductive composition different to the first and second conductor compositions disclosed herein is typically utilized for the via filling thick film conductive composition. This conductive composition is usually applied by standard screen printing techniques, however, any suitable application technique may be employed. Each layer of circuitry is typically completed by screen printing conductor tracks. Also, resistor inks or high dielectric constant inks can be printed on selected layer(s) to form resistive or capacitive circuit elements. Conductors, resistors, capacitors and any other components are typically formed by conventional screen printing techniques.

The conductor composition(s) of the present invention may be printed on the outermost layers of the circuit, either before or after lamination. The outermost layers of the circuit are used to attach components. Components are typically wire-bonded, glued or soldered to the surface of fired parts. In the case of a soldered component, the conductor composition of the present invention is particularly useful as it may have superior thermal aged and thermal cycle adhesion over prior art compositions.

After each layer of the circuit is completed, the individual layers are collated and laminated. A confined uniaxial or isostatic pressing die is typically used to ensure precise alignment between layers. The assemblies are trimmed to an appropriate size after lamination. Firing is typically carried out in a conveyor belt furnace or in a box furnace with a programmed heating cycle. The tape may be either constrained or free sintered during the firing process. For example, the methods disclosed in U.S. 4,654,095 to Steinberg and U.S. 5,254,191 to Mikeska and U.S. Patent Publication 2003/023407 to Wang may be utilized, as well as others known to those skilled in the art.

As used herein, the term "firing" means heating the assembly in an oxidizing atmosphere, such as air to a temperature, and for a time sufficient to volatilize (burn-out) the organic material in the layers of the assemblage and allow reaction and sintering of the inorganic components of both the tape and conductors. "Firing" causes the inorganic components in the layers, to react or sinter, and thus densify the entire assembly, thus forming a fired article. This fired article may be a multilayered circuit used in telecom and automotive applications (such as automotive vehicles).

The term "functional layer" refers to the printed Green Tape™, which has conductive, resistive, capacitive or dielectric functionality. Thus, as indicated above, a typical Green Tape™ layer may contain one or more conductive traces, conductive vias, resistors and/or capacitors.

### EXAMPLES

The invention will now be described in further detail with Examples 1-8. Examples 3 and 7 represent single conductor composition prints for comparative purposes.

### Test Procedures used in the examples in TABLE 1

A dielectric paste, product number QM44D manufactured and sold by E. I. du Pont de Nemours and Company, was printed using a 280 mesh screen onto an alumina substrate and dried. All drying steps in this procedure were carried out at 150°C for 10 minutes. The alumina substrate and dielectric print were then fired using a 30 minute 850°C profile with 10 minutes at the peak temperature. A second dielectric print was then applied to the previously fired print in a like manner and again dried; however, it was not fired at this time. Then, a conductor print of QM18 was applied (325 mesh screen) to the dried dielectric surface. This material was also dried. QM18 is manufactured and sold by E. I du Pont de Nemours and Company. Finally, a second conductor composition, selected form QS300 or 5082 was printed (325 mesh screen) and dried over the first dried conductor composition using the same pattern as the previous step. Both QS300 and 5082 are manufactured and sold by E. I. du Pont de Nemours and Company. Finally, the substrate, the second dielectric print, the first and second conductor prints were co-fired on the same firing profile as described previously.

In the case of examples 3 and 7, both of which are experimental controls, only a single conductor composition QM22 was printed using a 230 mesh screen and co-fired with the second dielectric layer. QM22 is manufactured and sold by E. I. du Pont de Nemours and Company.

Additional single print comparisons made in the same way as for Examples 1 through 8 were also prepared. These are Examples 9 through 12.

### Soldered adhesion strength test method

A typical adhesion test pattern comprises a simple 3*3 matrix of 2mm*2mm pads was used for Examples 9-12 of Table 2. For Examples 1-8, of Table 1, a single row of 2mm*2mm pads was used. Fired thickness of each conductor was between 10 to 14µm. None of the conductor compositions described herein showed observable distortion on the dielectric whether sequentially or co-fired.

For all adhesion tests, three clip-like wires were attached across each row of 3 pads (or across the single pad in the case of Examples 1-9) and either dip soldered (Examples 9-12) or soldered using solder paste (Examples 1-8) using 60Sn/40Pb (Sn/Pb) and 95Sn/5Ag solders for all testing. Examples 1-8 were performed using solder paste (available from Alpha Metals (60/40 or 95/5).

For Examples 1-8 using the solder paste, the 60Sn/40Pb solder paste was heated to 240C +/-5C for ten seconds. The 95Sn/5Ag solder paste was heated to 260C +/-5C for ten seconds. Additionally, the wire used with the 95Sn/5Ag solder paste was lead free. The wire was Sn coated copper wire.

The parts with 60Sn/40Pb were dip soldered at 240C +/-5C for ten seconds. The parts with 95Sn/5Ag were dip soldered at 260C +/-5C for ten seconds. After soldering, residual solder flux was cleaned from the soldered wire parts with Arcosolve (supplier). The parts were then divided into individual test samples for initial adhesion, thermal aged adhesion (150°C soak) or thermal cycled adhesion (-40 to 125°C, 2 hour per cycle). A sample set consists of three to four parts for each test condition.

The parts were allowed to rest at room temperature for 16 hours after being soldered. For adhesion testing, the wire leads were bent to 90° in accord with the bending marks printed on each part and tensile strength was measured for each pad. The average of three (3) pads per part for three to four parts as measured was used as the adhesion strength of the thick film conductor applied to the substrate. This format was used for all adhesion testing.

### Thermal cycling and thermal-cycled adhesion

After soldering and cleaning, parts were placed in a thermal-cycle chamber which was then cycled between -40 and 125°C every two hours. Parts were taken out for testing at different intervals (cycles). The nominal number of cycles chosen was 0, 100, 250, 500 750 and 1000. The actual intervals chosen varied and the choice depended on the nature of the intermediate test results obtained.

After adhesion testing as described above, the failure mode combined with adhesion value was used to evaluate acceptability. Failure was defined as visible substrate cracking, particularly important where the substrate is fired dielectric, and adhesion pull strength values below 12 newtons. The results are depicted in TABLE 1 and TABLE 2.

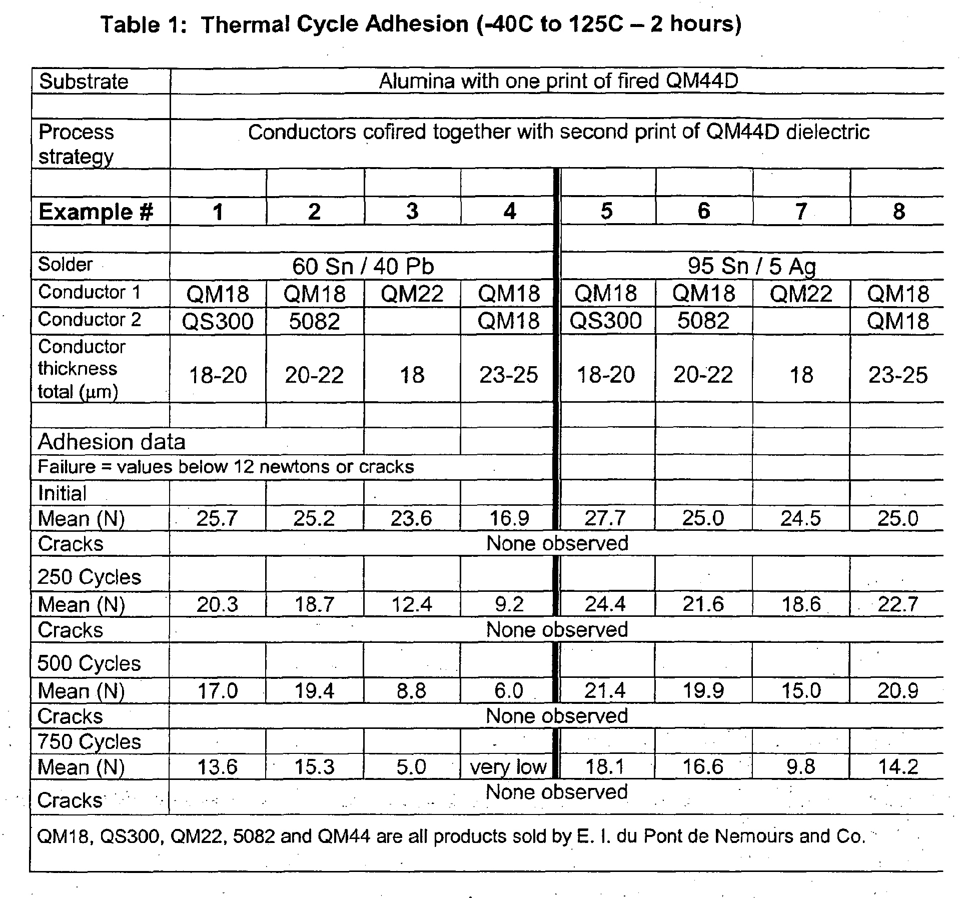

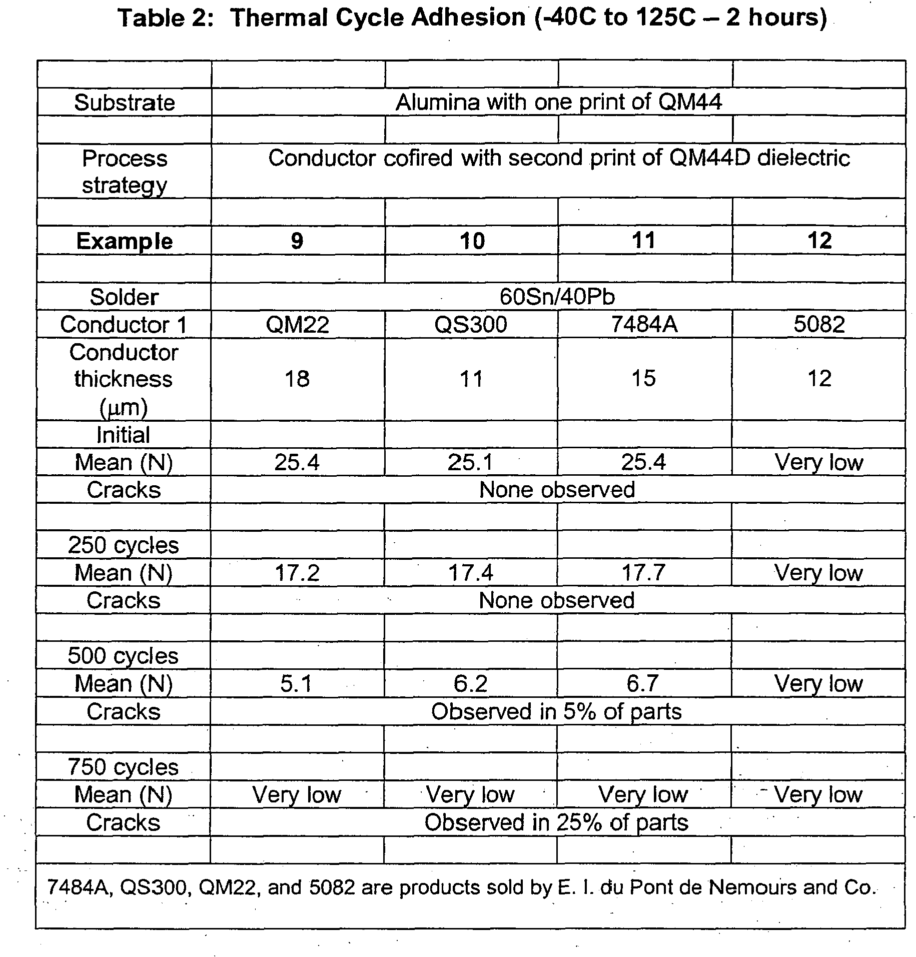

The data' in TABLE 1 show that the dual metallizations withstand thermal cycling better then single metallizations and meet the required specification of no cracking and adhesion values in excess of 12N after 750 cycles. This is not the case with all combinations. Selection of the right combinations is key to obtaining the required result.

## Claims

1. A method of forming an electronic circuit comprising:
(a) the application of a first conductor composition to a substrate, the first conductor composition comprising a silver metal powder or a mixture of silver and platinum powders, an inorganic binder, and an organic medium;
(b) the drying of said first conductor composition to form a dried first metal layer;
(c) the firing of said substrate and said dried first metal layer at a temperature sufficient to drive off the organic medium and to sinter the metal powder thereby forming first fired metal conductor layer of a fired dual metal layer;
(d) the application of a second conductor composition to the first fired conductor metal layer such that said first fired metal layer is covered by the second conductor composition, the second conductor composition comprising a silver metal powder or a mixture of silver and platinum metal powders and an organic medium;
(e) the drying of the said second conductor composition forming a second dried metal layer;
(f) the firing of said second dried metal layer at a temperature sufficient to drive off the organic medium and to sinter the metal powder of the second conductor composition thereby forming a second layer of a dual metal layer.

2. A method of forming an electronic circuit comprising:
(a) the application of a first conductor composition to a substrate, the conductor composition comprising a silver metal powder or a mixture of silver and platinum metal powders, an inorganic binder, and an organic medium;
(b) the drying of said first conductor composition to form a dried first metal layer;
(c) the application of a second conductor composition to the dried first metal layer such that said first dried metal layer is covered by the second conductor composition, the second conductor composition comprising a silver metal powder or a mixture of silver and platinum metal powders and an organic medium;
(d) the drying of the said second conductor composition forming a second dried metal layer;
(e) the cofiring of said substrate, first dried metal layer and second dried metal layer at a temperature sufficient to drive off the organic medium and to sinter the metal powder of said first and second conductor compositions thereby forming a dual metal layer.

3. A method of forming a multilayered ceramic circuit comprising:
(a) the application of a dielectric composition to previously-fired dielectric layer or layers all on an alumina substrate to form an alumina and dielectric substrate;
(b) the drying of said dielectric composition to form a dried dielectric layer;
(c) the application of a conductor via fill composition to provide eventual interconnection through the dielectric layer to connect conductor layers above and below said dielectric layer, said via fill composition comprising a metal powder of silver, inorganic additives such as oxides and glasses, and an inorganic medium;
(d) the drying of via fill composition in the vias of said dried dielectric layer;
(e) the application of a first conductor composition to said dried dielectric layer, and contacting the dried via fill composition in the vias of said dried dielectric layer, the first conductor composition comprising a metal powder consisting essentially of silver alone or a mixture of silver and platinum powders, an inorganic binder, and an organic medium;
(f) the drying of the said first conductor layer to form a first dried conductor layer;
(g) the application of a second conductor composition to said first dried metal layer such that said first dried metal layer is covered by the second conductor composition, the second conductor composition comprising a metal powder consisting essentially of silver alone or a mixture of silver and platinum powders and an organic medium;
(h) the drying of the said second conductor layer to form a second dried conductor layer.

4. The method of Claim 3 further comprising the firing of said alumina and dielectric substrate, dried via fill composition, first conductor layer and second conductor layer, such that the top of said dried dielectric layer, said dried via fill composition and said dried first and second conductor layers are co-fired at a temperature sufficient to drive off the organic medium and to sinter the metal powders in said first and second conductor layers and the ceramic powders in said dielectric layer thereby forming multiple metallization layers on top of a cofired dielectric layer it, in turn, having been processed on top of previously fired alternating conductor and dielectric layers.

5. The method of any one of Claims 1 or 2 wherein said substrate comprises alumina, beryllia, aluminum nitride, glass, dielectric paste, or dielectric tape.

6. The method of any one of Claims 1 or 2 further comprising positioning at least one metallized component on the surface of said dual metal layer and soldering the component to the surface of said dual metal layer.

7. The method of any one of Claims 1 or 2 wherein said substrate comprises a dielectric paste or a dielectric tape, comprising an amorphous partially crystallizable alkaline earth zinc silicate glass consisting essentially of a composition falling within the area defined on a weight points g-I of Figure 1 of the drawing, in which: (1) alpha is SiO2 in admixture with a glass former or conditional glass former selected from the group consisting of no more than 3 % Al2)3, 6% Hf02, 4% P2O5, 10% Ti)2, 6%Zr)2 and mixtures thereof, with the proviso that the composition contains at least 0.5% ZrO2; (2) beta is an alkaline earth selected from CaO, SrO, MgO, BaO and mixtures thereof, with the proviso that the composition contain no more than 15% MgO and no more than 6% BaO; and (3) gamma is ZnO, the loci of points g-I being as follows: point g - Alpha 48.0, Beta 32.0, Gamma 20.0; point h - Alpha 46.0, Beta 34.0, Gamma 20.0; point i - Alpha 40.0, Beta 34.0, Gamma 26.0; point j - Alpha 40.0, Beta 24.0, Gamma 36.0; point k - Alpha 46.0, Beta 18.0, Gamma 36.0; point k - Alpha 46.0, Beta 18.0, Gamma 36.0; point I - Alpha 48.0, Beta 19.0, Gamma 33.0.

8. The method of any one of Claims 1, 2, or 3 wherein said second conductor composition further comprises an inorganic binder.

9. A circuit formed by the method of any one of Claims 1, 2, or 3.
